# FASCICULE DE BREVET EUROPEEN

(11) **EP 0 576 340 B1**
(45) Date de publication et mention de la délivrance du brevet: **01.10.1997**
(21) Numéro de dépôt: 93401588.4
(22) Date de dépôt: 22.06.1993
(51) Int. Cl.: H03H 9/64, H03H 9/145

(54) **Filtre à ondes de surface à réseaux réfléchissants**
Oberflächenwellenfilter mit reflektierenden Gittern
Surface wave filter with reflective arrays

(30) Priorité: 26.06.1992 FR 9207883
(43) Date de publication de la demande: 29.12.1993
(73) Titulaire: THOMSON-CSF, 75008 Paris (FR)
(72) Inventeur: Solal, Marc, F-92402 Courbevoie Cedex (FR); Desbois, Jean, F-92402 Courbevoie Cedex (FR); Dufilie, Pierre, F-92402 Courbevoie Cedex (FR)
(74) Mandataire: Desperrier, Jean-Louis

(56) Documents cités:
- US-A- 3 872 410
- US-A- 3 883 831
- US-A- 4 004 254
- IEEE 1986 ULTRASONICS SYMP PROC 17/19-11- 1986, WILLIAMSBURG US; P59-64 ; T.KODAMA et al: design of low-loss saw filters employing darts

## Description

La présente invention se rapporte aux filtres à ondes de surface qui utilisent des réseaux réfléchissants afin d'améliorer la courbe de réponse du filtre et de réduire son encombrement.

Les filtres à ondes de surface sont bien connus dans l'Art. Ils comportent généralement à la surface d'un substrat piézoélectrique un transducteur émetteur et un transducteur récepteur, parfois séparés par un dispositif tel qu'un réseau, qui intervient sur l'onde de surface se propageant entre l'émetteur et le récepteur. Les caractéristiques du filtre, en particulier sa bande passante, dépendent des caractéristiques des deux transducteurs et de celles du dispositif intermédiaire. On a proposé et utilisé jusqu'à présent de nombreuses combinaisons permettant d'obtenir de tels filtres, mais les caractéristiques obtenues, bien que très satisfaisantes, ne permettent pas toujours de résoudre tous les problèmes. Pour parvenir quand même à une solution on en est parfois réduit à mettre plusieurs filtres en cascade, ce qui n'est pas très satisfaisant, en particulier pour des raisons de pertes d'insertion et de coût. En outre la nature même d'un filtre à ondes de surface où se succèdent linéairement différents dispositifs amène à obtenir un dispositif de longueur importante par rapport à sa largeur, ce qui entraîne aussi des difficultés d'encombrement.

On connaît, notamment de la demande de brevet français n°83 13747 déposée au nom de la demanderesse le 20 Octobre 1989, et délivrée sous le n°2653632 le 26 Avril 1991, des transducteurs unidirectionnels, connus sous le nom de DART, qui permettent d'émettre ou de recevoir une onde acoustique essentiellement d'un seul côté, ce qui améliore beaucoup le rendement du transducteur. En outre divers perfectionnements à ces DART permettent d'obtenir déjà au niveau du transducteur des caractéristiques de filtrage intéressantes. Toutefois, du fait de leur conception, les DART sont des dispositifs dont la longueur est relativement grande, typiquement plusieurs centaines de λ (λ est la longueur d'onde à la fréquence centrale de fonctionnement des dispositifs). En conséquence un filtre comportant deux DART, l'un en entrée et l'autre en sortie, nécessite d'utiliser un substrat nettement plus long que large, même si aucun autre élément du filtre n'est disposé entre les deux transducteurs. On est alors conduit à utiliser un boîtier non standard, lui-aussi nettement plus long que large, qui s'insère mal dans les systèmes d'implantation habituelle et qui en outre présente des faiblesses en torsion et en flexion. Si on veut néanmoins utiliser pour le DART un boîtier standard, il faut perdre beaucoup de place en largeur.

S. Gopani et Cie ont proposé dans un article publié par l'IEEE dans 1990 Ultrasonics Symposium, pages 55 à 59, un filtre à ondes de surface d'un type dit RAF (abréviation de "Reflective Array Filter"), dans lequel l'onde acoustique issue d'un transducteur émetteur simple est réfléchie à 90° sur un premier réflecteur, puis en sortie de ce premier réflecteur de nouveau à 90° sur un second réflecteur, de manière à revenir dans la même direction, mais dans le sens opposé par rapport à sa sortie de l'émetteur, sur un transducteur récepteur simple situé sur le substrat au même niveau que le transducteur émetteur. Le trajet des ondes acoustiques suit donc un trajet en forme de U. De ce fait la longueur du filtre est sensiblement réduite, alors que sa largeur est augmentée environ d'un facteur 2. Toutefois les caractéristiques de filtrage d'un tel filtre ne sont pas sensiblement modifiées par rapport à celles d'un filtre simple ordinaire.

On cherche en outre pour des besoins particuliers à réaliser des filtres à ondes de surface dont la réjection dite lointaine, c'est-à-dire l'affaiblissement du niveau des lobes secondaires, soit inférieure à -80dB pour une bande passante relative de quelques pour-cent, qui correspond donc à un lobe principal de faible largeur. En outre il est souhaitable de ne pas avoir de perte d'insertion plus grande que -10dB.

Pour obtenir de telles caractéristiques avec des filtres connus on est amené à en mettre plusieurs en cascade, ce qui automatiquement augmente les pertes d'insertion, que l'on a déjà du mal à maintenir dans les limites ci-dessus.

Pour pallier ces inconvénients, l'invention propose un filtre à ondes de surface tel que définis par la revendication 1.

D'autres particularités et avantages de l'invention apparaîtront clairement dans la description suivante faite à titre d'exemple non limitatif en regard des figures annexées qui représentent :
- La figure 1, le schéma de principe d'un filtre selon l'invention ;
- La figure 2, un détail de réalisation d'un réflecteur de la figure 1 ;
- La figure 3, un schéma électrique équivalent d'un filtre selon l'invention ;
- La figure 4, le schéma de principe d'une variante d'un filtre selon l'invention ;
- La figure 5, le schéma de principe d'une deuxième variante d'un filtre selon l'invention ; et
- La figure 6, une courbe de réponse type d'un filtre construit selon l'invention ;

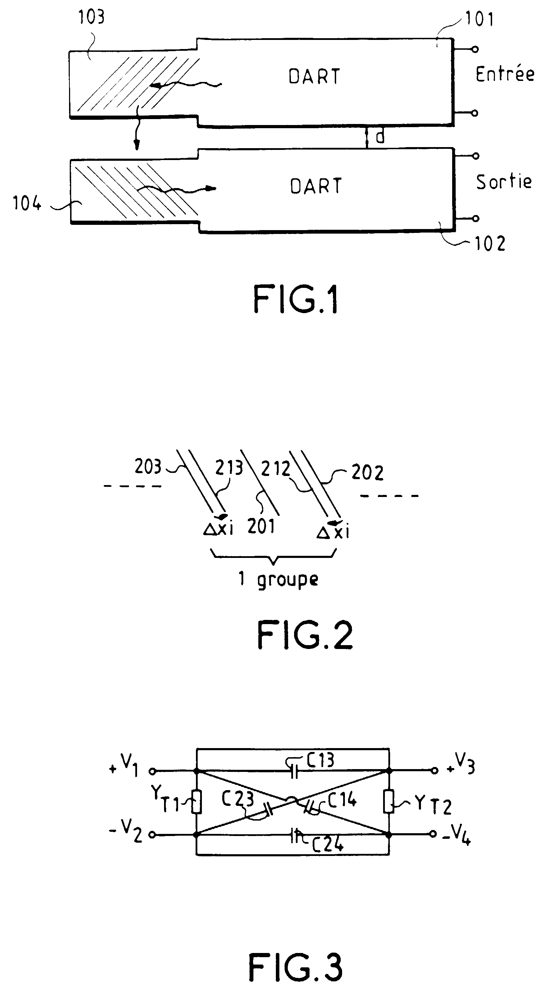

Dans le mode de réalisation représenté sur la figure 1, le filtre selon l'invention comporte, sur un substrat non représenté, un transducteur émetteur 101 auquel est appliqué le signal d'entrée et un transducteur récepteur 102 délivrant le signal de sortie. Selon l'invention, ces transducteurs sont du type unidirectionnel dit DART. La structure de tels transducteurs est suffisamment connue pour qu'on ne les représente schématiquement sur la figure que par des rectangles.

Les ondes acoustiques émises par le transducteur 101 partent vers la gauche ae la figure, elles sont réfléchies à 90° vers le bas de la figure par un premier réseau 103 puis à 90° vers la droite de la figure par un deuxième réseau 104 qui les renvoie sur l'entrée du transducteur récepteur 102.

L'invention réside donc dans la combinaison des deux transducteurs de type DART avec les deux réseaux réfléchissants à 90°.

Ces réseaux réfléchissants sont eux-mêmes formés, de manière connue, sous forme de traits inclinés à environ 45° sur le trajet des ondes acoustiques et formant des discontinuités ou perturbations sur la surface du substrat piézoélectrique où se propagent les ondes. Ces discontinuités ou perturbations peuvent être en surépaisseur et être formées alors avantageusement d'une couche métallique convenablement déposée. On peut aussi les réaliser sous forme de sillons gravés en creux dans la surface du substrat.

La fonction de transfert global du filtre est au premier ordre égale au produit des fonctions de transfert du transducteur d'entrée, des réseaux réfléchissants, et enfin du transducteur de sortie.

La réjection des lobes secondaires du filtre ainsi obtenue est particulièrement importante, car elle combine le fort taux de réjection intrinsèque des transducteurs unidirectionnels de type DART à la réjection des réseaux réfléchissants de type incliné, qui est plus importante que celle des réseaux du type à bandes verticales.

Diverses méthodes sont utilisables pour synthétiser la fonction de transfert - ou la réponse impulsionnelle, ce qui est équivalent - des réseaux réfléchissants 103 et 104.

La première méthode consiste à grouper les traits réfléchissants du réseau, appelés réflecteurs par simplification, par groupes comportant chacun k réflecteurs, k étant souvent égal à 3. Pour obtenir la pondération permettant d'obtenir la synthèse, on décale alors les réflecteurs d'un groupe par rapport à leur position théorique correspondant à la longueur d'onde centrale λ du filtre. Cette méthode est appelée pondération par position.

Un tel décalage est par exemple représenté sur la figure 2 pour un groupe comportant trois réflecteurs 201, 202 et 203. Ces réflecteurs sont représentés avec ces références dans leur position de base, correspondant justement à la longueur d'onde λ. Pour obtenir la pondération souhaitée, on laisse le réflecteur central 201 dans cette position et on déplace les réflecteurs 202 et 203 vers celui-ci d'une distance Δxi, pour les placer donc sur les emplacements portant les références 212 et 213.

Pour les trois réflecteurs dans les positions 201 à 203 le coefficient de réflexion du groupe serait donné par 3r, r étant le coefficient de réflexion d'un seul réflecteur. Par contre avec un tel décalage le coefficient de réflexion est donné par r (1 + 2cos 2πΔxᵢ/λ). En choisissant Δxᵢ pour chaque groupe on peut ainsi synthétiser la fonction de transfert du réseau comportant ces groupes. Cette méthode, appelée pondération par position, est une variante de celle décrite dans l'article de 1990 Ultrasonics Symposium cité plus haut.

Une deuxième méthode de synthèse de la fonction de transfert des réflecteurs est la méthode classique de suppression de sources, qui consiste à supprimer un certain nombre de réflecteurs de manière à pondérer une zone par la densité relative de réflecteurs. Cette méthode est connue sous la terminologie anglo-saxonne de Withdrawal Weighting.

On peut également pondérer les réflecteurs du type sillons gravés en faisant varier la profondeur de gravure. Toutefois cette méthode est onéreuse, car elle oblige à faire une opération de gravure supplémentaire.

En outre les deux premières méthodes décrites ci-dessus peuvent s'appliquer aussi aux sillons gravés en gardant une profondeur de gravure constante pour ceux-ci.

Compte tenu de la disposition respective des transducteurs 101 et 102 l'un par rapport à l'autre, il est clair que, par opposition aux filtres classiques où les transducteurs sont disposés respectivement à chaque extrémité du substrat, on a un risque de couplage électromagnétique direct entre eux plus important, en particulier par la capacité parasite entre les deux transducteurs.

Pour réduire ce couplage jusqu'à la valeur maximale tolérable, la première solution consiste bien entendu à augmenter la distance d qui sépare les deux transducteurs. Cette solution n'est pas totalement satisfaisante, car pour obtenir un résultat compatible avec la réjection souhaitée des lobes secondaires on est conduit à avoir une distance d excessive vis-à-vis des autres dimensions du dispositif.

On peut alors appliquer, simultanément ou séparément, d'autres mesures permettant de diminuer ce couplage.

L'une de ces mesures consiste à réduire au maximum l'épaisseur du substrat et à rendre conductrice la face inférieure de ce substrat, par métallisation ou collage à l'aide d'une colle conductrice par exemple. La capacité parasite est alors réduite par un effet de blindage.

Un autre moyen consiste à faire une encoche, à la scie par exemple, entre les deux transducteurs, et à rendre conductrice cette encoche, par exemple en la remplissant avec un clinquant métallique ou une colle conductrice réunie à la masse. Là aussi on obtient un effet de blindage.

En général, les vitesses des ondes ne sont pas les mêmes suivant les deux axes perpendiculaires de propagation à la surface du substrat, ce qui entraîne que les réflecteurs ne sont pas inclinés exactement à 45°, mais à une valeur adéquate permettant d'obtenir une réflexion à 90°. En soi ceci ne pose pas de problème, mais malheureusement les vitesses varient de manières différentes avec la température pour certains matériaux comme le quartz.

Dans ces conditions, lorsque la température s'écarte de celle pour laquelle l'inclinaison des réflecteurs a été calculée, l'angle de réflexion change par rapport à sa valeur théorique de 90° et les plans de phase des ondes ne sont plus parallèles aux électrodes des DART. Ceci entraîne une déformation de la fonction de transfert du filtre dès que la température s'éloigne de la température de consigne et une augmentation des pertes.

Une solution connue par ailleurs à ce problème consiste à utiliser un quartz taillé selon une coupe compensée en température. Une telle méthode est décrite dans un article publié par S.E. Oates dans IEEE Ultrasonics Symposium 1979 pages 691 à 695.

L'usage de cette coupe présente toutefois certaines difficultés, ce qui retentit forcément sur les coûts.

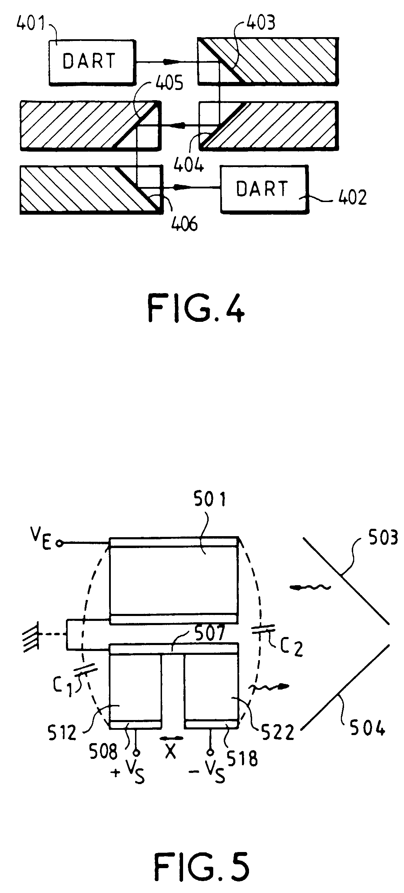

On peut alors utiliser pour compenser, tout au moins partiellement, cet effet de température, une variante de l'invention dans laquelle le trajet des ondes est doublement replié, comme représenté schématiquement sur la figure 4.

Dans cette variante, on utilise deux transducteurs de type DART 401 et 402 situés aux deux extrémités d'une diagonale du substrat, supposé rectangulaire, et quatre réseaux réflecteurs 403 à 405 qui permettent d'obtenir un trajet de l'onde acoustique en forme de grecque.

En effet, l'onde acoustique partant du transducteur 401 s'en va horizontalement vers la droite de la figure vers le premier réflecteur 403, qui la renvoie verticalement vers le bas de la figure sur le deuxième réflecteur 404. Ce réflecteur 404 réfléchit l'onde acoustique horizontalement vers la gauche sur le troisième réflecteur 405, qui la réfléchit lui-même verticalement vers le bas vers le dernier réflecteur 406. Ce dernier renvoie finalement l'onde horizontalement vers la droite vers le transducteur de réception 402.

Dans ces conditions les écarts par rapport à l'angle de réflexion de 90°, dus à la température, se compensent sensiblement entre les quatre réflecteurs 403 à 406, et l'onde acoustique sortant du transducteur 401 est toujours parallèle à l'onde acoustique entrant dans le transducteur 402.

En outre cette structure présente deux avantages supplémentaires :
- Tout d'abord les deux transducteurs sont plus éloignés que précédemment, ce qui permet de réduire le couplage électromagnétique entre eux, sans avoir à utiliser les artifices décrits plus haut.
- De plus, l'usage de quatre réseaux réflecteurs, au lieu de deux, permet d'augmenter le nombre de paramètres utilisables pour synthétiser la fonction de filtrage, et d'augmenter l'affaiblissement des lobes secondaires.

Toutefois on augmente d'une manière non négligeable la taille du substrat, et donc du boîtier à utiliser, ce qui augmente les coûts. De plus, les pertes d'insertion sont par construction plus importantes. Cette variante sera donc utilisée plutôt dans le cas du quartz non compensé en température.

Une deuxième variante, qui permet de limiter au mieux le couplage électromagnétique entre les transducteurs d'entrée et de sortie, lorsque ceux-ci sont rapprochés comme dans la figure 1 et que les artifices vus plus haut ne permettent pas d'obtenir les performances souhaitées, est représentée sur la figure 5.

Dans cette variante, on utilise un transducteur émetteur de type DART 501 et deux réseaux réflecteurs 503 et 504, symbolisés ici par un simple trait incliné, tout à fait semblables à ceux de la figure 1.

Au niveau du transducteur récepteur par contre, on utilise deux transducteurs identiques 512 et 522 séparés par une distance X = λ/2 + kλ/2 de telle manière que les signaux électriques induits sur ces transducteurs soit en opposition de phase.

En utilisant une connexion commune 507 mettant en série ces deux transducteurs de sortie, on trouve des différences de potentiels opposées +Vs et -Vs entre les connexions 508 et 518 et la connexion commune 507. Dans le cas où les impédances de charge sur les pavés 508 et 518 sont symétriques, le point 507 sera naturellement à la masse. Il est possible de l'y relier ou pas.

Dans ce montage les deux capacités parasites C₁ et C₂ existant entre le transducteur d'entrée 501 et les deux transducteurs de sortie 512 et 522, dont les valeurs sont sensiblement égales, présentent des polarités opposées, ce qui diminue très fortement le couplage électromagnétique entre l'entrée et la sortie.

Il est bien clair que ce montage est réversible avec l'entrée située de manière différentielle sur les transducteurs 512 et 522 et la sortie sur le transducteur 501.

Lorsque les transducteurs d'entrée et de sortie sont alimentés en différentiel, le schéma électrique équivalent représenté sur la figure 3, dans lequel Y_{T1} et Y_{T2} sont les admittances des deux transducteurs, montre qu'il existe quatre capacités parasites C₁₃ à C₂₄.

Les calculs bien connus des réseaux électriques montrent que pour certaines combinaisons de ces capacités parasites le couplage entrée/sortie est nul. Bien entendu les capacités parasites effectivement obtenues n'ont aucune raison de remplir effectivement ce critère. Il est toutefois aisé d'y aboutir en mettant en parallèle sur ces capacités parasites des capacités d'ajustage supplémentaires correctement choisies pour équilibrer l'ensemble.

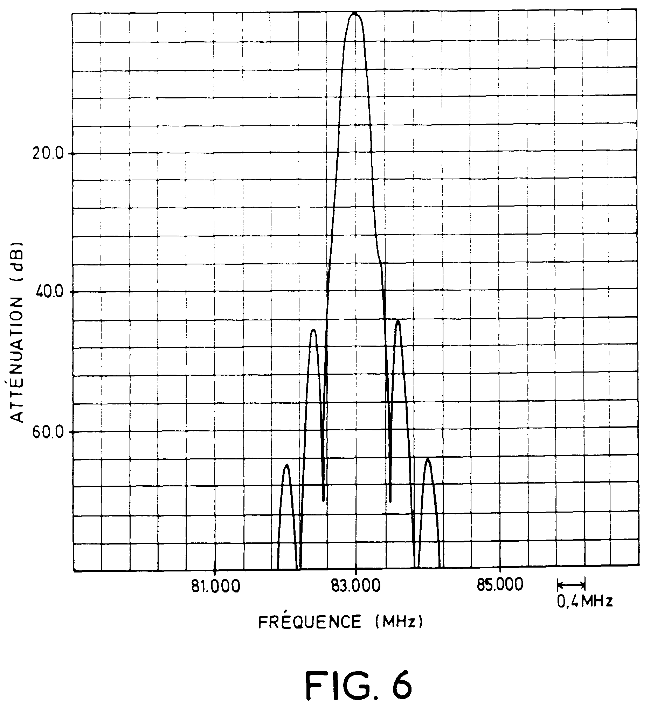

On a représenté sur la figure 6 la fonction de transfert d'un filtre selon l'invention, centré sur 83MHz et comportant deux transducteurs de type DART chacun d'une longueur de 207λ. Chaque transducteur comprend 121 cellules actives, 59 cellules réflectrices et 27 cellules inactives, la longueur de chaque cellule étant égale à λ. En outre chaque réseau réflecteur est composé de 100 bandes métalliques épaisses de 0,6µmètres et distantes de λ.

Ce filtre a été réalisé sur un substrat en quartz long de sensiblement 15mm et large de sensiblement 7 mm. Ces dimensions permettent de l'insérer dans un boîtier standard de type DIL14 dont les dimensions extérieures sont 22 x 12,5mm.

Par rapport à un filtre utilisant des DART identiques et un réflecteur, ou plutôt un coupleur, la comportant 200 bandes verticales, la longueur du substrat est réduite d'environ 25%. Il n'est d'ailleurs pas du tout certain que l'on obtiendrait avec un tel filtre linéaire les performances obtenues avec le filtre selon l'invention.

En effet ce filtre permet d'obtenir une perte d'insertion de seulement -7,5 dB avec une bande passante de 440 KhZ à -20 dB et une réjection supérieure à -80 dB.

## Revendications

1. Filtre à ondes de surface à réseaux réfléchissants, du type comprenant un transducteur d'entrée (101), un transducteur de sortie (102) et au moins deux réseaux réfléchissants à 90° (103,104) pour relier acoustiquement entre eux les deux transducteurs et disposés pour que le trajet de l'onde acoustique entre le transducteur d'entrée (101) et le transducteur de sortie (102) suive un trajet en forme de U, caractérisé en ce que deux transducteurs sont du type unidirectionnel à réflection distribuée, et en ce que l'un au moins des transducteurs est divisé en deux parties (512,522) pour pouvoir être connecté électriquement de manière différentielle afin de diminuer la capacité parasite (C₁, C₂) qu'il présente avec l'autre transducteur (501).

2. Filtre selon la revendication 1, caractérisé en ce que les deux transducteurs sont divisés en deux parties et qu'il comporte en outre des capacités d'ajustage supplémentaires éventuellement gravées sur le substrat pour équilibrer les capacités parasites (C₁₃ - C₂₄).

3. Filtre selon la revendication 1, caractérisé en ce qu'il comprend quatre réseaux réfléchissants (403-406) disposés pour faire parcourir à l'onde acoustique reliant le transducteur d'entrée (401) au transducteur de sortie (402) un trajet en forme de grecque qui minimise l'influence de la température sur le parcours des ondes acoustiques à la surface du substrat et qui permet d'éloigner au maximum les deux transducteurs.

## Patentansprüche

1. Oberflächenwellenfilter mit reflektierenden Gittern, mit einem eingangsseitigen Transduktor (101), einem ausgangsseitigen Transduktor (102) und mindestens zwei um 90° reflektierenden Gittern (103, 104), um die beiden Transduktoren akustisch miteinander zu verbinden und um einen Verlauf der akustischen Welle zwischen dem eingangsseitigen Transduktor (101) und dem ausgangsseitigen Transduktor (102) in Form eines U zu erzielen, dadurch gekennzeichnet, daß die beiden Transduktoren in einer Richtung wirksame Transduktoren mit verteilter Reflexion sind und daß mindestens einer der Transduktoren in zwei Teile (512, 522) unterteilt ist, um elektrisch differential angeschlossen werden zu können, so daß die Störkapazität (C1, C2), die dieser Transduktor mit dem anderen Transduktor (501) bildet, verringert wird.

2. Filter nach Anspruch 1, dadurch gekennzeichnet, daß beide Transduktoren je in zwei Teile aufgeteilt sind und daß außerdem zusätzliche Justierkondensatoren vorhanden sind, die ggf. auf dem Substrat eingraviert sind, um die Störkapazitäten (C13 bis C24) auszugleichen.

3. Filter nach Anspruch 1, dadurch gekennzeichnet, daß es vier reflektierende Gitter (403 bis 406) besitzt, die so angeordnet sind, daß die akustische Welle, die vom eingangsseitigen Transduktor (401) zum ausgangsseitigen Transduktor (402) verläuft, einen mäanderförmigen Weg nimmt, wodurch der Einfluß der Temperatur auf den Weg der akustischen Wellen auf der Oberfläche des Substrats verringert und der Abstand zwischen den beiden Transduktoren maximal vergrößert wird.

## Claims

1. Surface-wave filter with reflective arrays, of the type comprising an input transducer (101), an output transducer (102) and at least two 90° reflective arrays (103, 104) in order to connect the two transducers together acoustically, these arrays being arranged so that the path of the acoustic wave between the input transducer (101) and the output transducer (102) follows a U-shaped path, characterized in that two transducers are of the unidirectional distributed-reflection type and in that at least one of the transducers is split into two parts (512, 522) in order to be able to be electrically connected in a differential manner so as to decrease the stray capacitance (C₁, C₂) which it exhibits with the other transducer (501).

2. Filter according to Claim 1, characterized in that the two transducers are split into two parts and that it furthermore includes additional trimming capacitors, optionally etched on the substrate, in order to balance the stray capacitances (C₁₃ - C₂₄).

3. Filter according to Claim 1, characterized in that it comprises four reflective arrays (403 - 406) arranged in order to make the acoustic wave connecting the input transducer (401) to the output transducer (402) travel a path in the shape of a Greek fret which minimizes the effect of temperature on the path length of the acoustic waves on the surface of the substrate and which allows maximum separation of the two transducers.
